# EUROPEAN PATENT SPECIFICATION

(11) **EP 2 602 277 B1**
(45) Date of publication and mention of the grant of the patent: **05.11.2014**
(21) Application number: 11814751.1
(22) Date of filing: 05.08.2011
(51) Int. Cl.: C08G 73/06, B32B 5/28, C08J 5/24, C08K 9/06, C08L 79/04, H05K 1/03, C08G 77/16, C08G 77/452, C08L 83/10

(54) **PROCESS FOR PRODUCING COMPATIBILIZED RESIN, THERMOSETTING RESIN COMPOSITION, PREPREG, AND LAMINATE**
VERFAHREN ZUR HERSTELLUNG EINES KOMPATIBILISIERTEN HARZES, WÄRMEHÄRTENDE HARZZUSAMMENSETZUNG, PREPREG UND LAMINAT
PROCÉDÉ DE PRODUCTION DE RÉSINE COMPATIBILISÉE, COMPOSITION DE RÉSINE THERMODURCISSABLE, PRÉPREG ET STRATIFIÉ

(30) Priority: 06.08.2010 JP 2010177380
(43) Date of publication of application: 12.06.2013
(73) Proprietor: Hitachi Chemical Company, Ltd., Chiyoda-ku Tokyo 100-6606 (JP)
(72) Inventor: TSUCHIKAWA, Shinji, Chikusei-shi Ibaraki 308-8521 (JP); IZUMI, Hiroyuki, Chikusei-shi Ibaraki 308-8521 (JP); ISHIKURA, Kumiko, Chikusei-shi Ibaraki 308-8521 (JP); MURAI, Hikari, Chikusei-shi Ibaraki 308-8521 (JP)
(74) Representative: Hoffmann Eitle
(86) International application number: PCT/JP2011/067985
(87) International publication number: WO 2012/018126

(56) References cited:
- EP-A1- 1 275 696
- JP-A- 10 287 809
- JP-A- 2000 034 345
- JP-A- 2001 339 130
- JP-A- 2002 309 084
- JP-A- 2009 035 728

## Description

### [Technical Field]

The present invention relates to a process for producing a compatibilized resin from which a thermosetting resin composition which is excellent in terms of low thermal expansion, adhesiveness to copper foil, heat resistance, flame retardancy, copper-clad heat resistance (T-300), dielectric characteristics, and drillability is obtained, a thermosetting resin composition, a prepreg, and a laminate.

### [Background Art]

Thermosetting resin compositions have a crosslinking structure and exhibit high heat resistance and dimensional stability, and therefore, they are widely used in the fields of electronic appliances and the like. In particular, the thermosetting resin compositions are used for printed wiring boards having a wiring or a circuit pattern printed thereon, prepregs constituting a copper clad laminate obtained by multilayering printed circuit boards, and interlayer insulating materials.

In recent years, miniaturization, weight reduction, and increase in speed of clock frequency of electronic appliances are remarkably advanced, and high density integration of printed wiring and circuit pattern is advanced. As a method for achieving high density integration, there is proposed thinning of a printed wiring and a circuit pattern to be formed on a printed wiring board, multilayering of a circuit substrate having a circuit pattern formed thereon, or a combination thereof.

For example, even in the case where a printed wiring and a circuit pattern are thinned, a copper clad laminate is required to be provided with peel strength such that a conductor layer constituting the printed wiring and the circuit pattern is not peeled off.

That is, in view of requirements for high density and high reliability in recent years, laminate materials are considered to be needed to be provided with high adhesiveness to copper foil, heat resistance, good low thermal expansion, and the like. However, for the purpose of forming a fine wiring, so far as the adhesiveness to copper foil is concerned, its copper foil peel strength is desirably 1.0 kN/m or more, and more desirably 1.2 kN/m or more. In addition, for the purpose of achieving high density, it is also necessary to achieve high multilayering using a build-up material or the like, and high reflow heat resistance is needed. However, as for copper-clad heat resistance (T-300) serving as a guideline to the evaluation of reflow heat resistance, it is desirable that expansion or the like is not generated for 30 minutes or more.

Furthermore, following the high density of a laminate material, a base material tends to be made thinner, and it is necessary that a warp of the base material at the time of heat treatment is small. For the purpose of achieving a low warp, it is effective that the surface direction of the base material is of low thermal expansion, and its coefficient of linear expansion is desirably not more than 7 ppm/°C, and more desirably not more than 5 ppm/°C. In addition, following the high density, a base material tends that more reliability is required, and it is also necessary that a hole wall roughness of a drill hole at the time of drill processing is small. The hole wall roughness of a drill hole is evaluated in terms of permeability of plated copper, and a plating permeation depth is desirably not more than 20 µm, and more desirably not more than 15 µm at maximum. Furthermore, a requirement for high-speed response continues to increase, and it is desirable that the base material has a relative dielectric constant of not more than 4.7 and a dielectric tangent of not more than 0.010.

In this way, in view of the requirements for high density and high reliability on the laminate materials, the thermosetting resin compositions which are used as an insulating resin are required to be provided with high-level characteristics, and the development of a resin composition satisfying all of these characteristics is being advanced.

In addition, in view of environmental issues in recent years, mounting of an electronic part prepared using a lead-free solder and halogen-free flame retardation are required, and accordingly, higher heat resistance and flame retardancy than those in the conventional technologies are considered to be needed. Furthermore, for the purposes of ensuring safety of products and enhancing the work environment, thermosetting resin compositions which are constituted of only low toxicity components and which do not generate toxic gases or the like are desired.

Though a cyanate compound that is a thermosetting resin is a resin with excellent dielectric characteristics and flame retardancy, in the case where it is used directly for a thermosetting resin of epoxy curing system, its heat resistance and toughness are not sufficient, and low thermal expansion is further desired as a thermosetting resin compatible with the next generation.

Accordingly, resin compositions composed of a cyanate compound and an inorganic filler and capable of exhibiting low thermal expansion are disclosed in Patent Documents 1, 2 and 3. But, in the case where in order to exhibit the low thermal expansion, the blending amount of the used inorganic filler is increased, and such a resin composition is used as a copper clad laminate or an interlayer insulating material, the drillability and moldability are insufficient.

In addition, thermosetting resins that contain a cyanate resin and an aralkyl-modified epoxy resin as essential components in order to exhibit the low thermal expansion are disclosed in Patent Documents 4 and 5. But, since this cyanate resin as an essential component is a resin which is inferior in terms of toughness and curing reactivity, improvements in the curing reactivity and toughness are still insufficient. Even in the case of using such a thermosetting resin as a copper clad laminate or an interlayer insulating material, it is insufficient in terms of heat resistance, reliability, processability, and the like.

### [Prior Art Documents]

### [Patent Documents]

[Patent Document 1] JP-A-2003-268136
[Patent Document 2] JP-A-2003-73543
[Patent Document 3] JP-A-2002-285015
[Patent Document 4] JP-A-2002-309085
[Patent Document 5] JP-A-2002-348469

### [Summary of the Invention]

### [Problems to be Solved by the Invention]

In view of these present circumstances, an object of the present invention is to solve the foregoing problems in the case of using the cyanate compound that is a thermosetting resin and to provide a thermosetting resin composition which is excellent in terms of low thermal expansion, adhesiveness to copper foil, heat resistance, flame retardancy, copper-clad heat resistance (T-300), dielectric characteristics, and drillability, and a prepreg, a laminate, and a wiring board each using the same.

### [Means for Solving the Problems]

In order to solve the foregoing problems, the present inventors made extensive and intensive investigations. As a result, it has been found that by using a resin composition containing (A1) a compatibilized resin or (A2) a thermosetting resin, which is obtained by reacting a cyanate compound with a siloxane resin having a hydroxyl group at an end thereof or further with an epoxy resin at a specified rate of reaction, and (B) fused silica having been subjected to a surface treatment with a trimethoxysilane compound, an excellent thermosetting resin composition having the foregoing characteristics is obtained, leading to accomplishment of the present invention. The present invention has been accomplished on the basis of such knowledge.

Specifically, the present invention is to provide a process for producing a compatibilized resin, a thermosetting resin composition, a prepreg, a laminate, and a wiring board as described below.
(1) A process for producing a compatibilized resin having an iminocarbonate structure and a triazine structure, comprising reacting (a) a siloxane resin having a hydroxyl group at an end thereof, which is represented by the following general formula (I), (b) a compound having at least two cyanate groups in one molecule thereof, and (c) a compound having at least two epoxy groups in one molecule thereof, with proportions of the component (a), the component (b), and the component (c) being from 10 to 50 parts by mass, from 40 to 80 parts by mass, and from 10 to 50 parts by mass, respectively based on 100 parts by mass of a total amount of the components (a) to (c), in the presence of (d) an organic metal salt in a solvent selected among toluene, xylene, and mesitylene at from 80 to 120°C at a rate of reaction of the component (b) of from 30 to 70 % by mole. 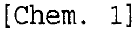 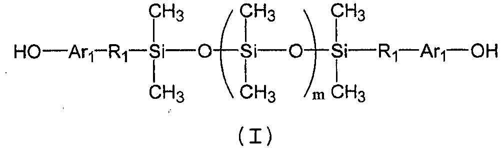 (In the formula, each R₁ independently represents an alkylene group or an alkylene oxy group each having a carbon number of from 1 to 5 ; each Ar₁ independently represents a single bond, an arylene group, or an alkylene group having a carbon number of from 1 to 5; and m represents an integer of from 5 to 100.)
(2) A thermosetting resin composition comprising (A1) a compatibilized resin produced by the process as set forth above in (1) and (B) fused silica having been subjected to a surface treatment with a trimethoxysilane compound represented by the following formula (II). 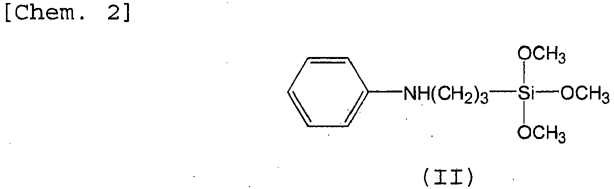
(3) A thermosetting resin composition comprising (A2) a thermosetting resin and (B) fused silica having been subjected to a surface treatment with a trimethoxysilane compound represented by the formula (II), wherein
   the thermosetting resin (A2) is a resin obtained by reacting (a) a siloxane resin having a hydroxyl group at an end thereof, which is represented by the general formula (I), and (b) a compound having at least two or more cyanate groups in one molecule thereof in an organic solvent,
   from 10 to 70 parts by mass of the siloxane resin (a) and from 30 to 90 parts by mass of the compound (b) are contained based on 100 parts by mass of a total sum of the siloxane resin (a) and the compound (b), and
   a rate of reaction of the compound (b) is from 40 to 70 % by mole.
(4) A prepreg obtained by impregnating or coating a base material with the thermosetting resin composition as set forth above in (2) or (3) and then bringing it into a B-stage.
(5) A laminate formed using the prepreg as set forth above in (4).

### [Effects of the Invention]

The prepreg obtained by impregnating or coating a base material with the thermosetting resin composition according to the present invention and the laminate produced by subjecting the prepreg to laminate molding are excellent in terms of all of low thermal expansion, adhesiveness to copper foil, heat resistance, flame retardancy, copper-clad heat resistance (T-300), dielectric characteristics, and drillability, free from the environmental issues, and excellent in terms of safety of products, and therefore, they are extremely useful as a printed wiring board for electronic appliance.

### [Modes for Carrying Out the Invention]

The present invention is hereunder described in detail.

First of all, the process for producing (A1) a compatibilized resin according to the present invention is a process comprising subjecting (a) a siloxane resin having a hydroxyl group at an end thereof, which is represented by the following general formula (I), (b) a compound having at least two cyanate groups in one molecule thereof, and (c) a compound having at least two epoxy groups in one molecule thereof, with proportions of the component (a), the component (b), and the component (c) being from 10 to 50 parts by mass, from 40 to 80 parts by mass, and from 10 to 50 parts by mass, respectively based on 100 parts by mass of a total amount of the components (a) to (c), to an iminocarbonation reaction and a triazine ring-forming reaction in the presence of (d) an organic metal salt in a solvent selected among toluene, xylene, and mesitylene at from 80 to 120°C at a rate of reaction of the component (b) of from 30 to 70 % by mole. 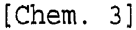 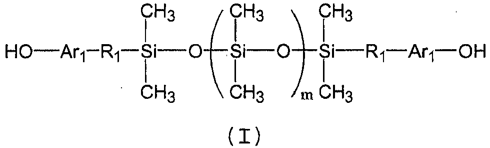 (In the formula, each R₁ independently represents an alkylene group or an alkylene oxy group each having a carbon number of from 1 to 5; each Ar₁ independently represents a single bond, an arylene group, or an alkylene group having a carbon number of from 1 to 5; and m represents an integer of from 5 to 100.)

Incidentally, the iminocarbonation reaction is a reaction for forming an iminocarbonate bond (-O- (C=NH) -O-) by an addition reaction of a hydroxyl group and a cyanate group, and the triazine ring-forming reaction is a reaction for forming a triazine ring by trimerizing a cyanate group. In addition, three-dimensional network structurization is advanced by the reaction in which this cyanate group is trimerized to form a triazine ring, and at that time, the compound (c) having at least two epoxy groups in one molecule thereof is uniformly dispersed in the three-dimensional network structure, whereby a compatibilized resin in which the component (a), the component (b), and the component (c) are uniformly dispersed is produced.

The siloxane resin as the component (a), which is used for the production of the compatibilized resin (A1) according to the present invention, is not particularly limited so far as it is a siloxane resin containing a hydroxyl group, which has a structure represented by the foregoing general formula (I). Examples thereof include siloxane resins having a phenolic hydroxyl group at both ends thereof, such as a trade name: X-22-1821 (hydroxyl value: 35 KOH mg/g) and a trade name: X-22-1822 (hydroxyl value: 20 KOH mg/g), both of which are manufactured by Shin-Etsu Chemical Co. , Ltd. , and a trade name: BY16-752A (hydroxyl value: 30 KOH mg/g), manufactured by Dow Corning Tray Co., Ltd.; siloxane resins having an alcoholic hydroxyl group at both ends thereof, such as a trade name: X-22-160AS (hydroxyl value: 112 KOH mg/g), a trade name: KF-6001 (hydroxyl value: 62 KOH mg/g), a trade name: KF-6002 (hydroxyl value: 35 KOH mg/g), a trade name: KF-6003 (hydroxyl value: 20 KOH mg/g), and a trade name: X-22-4015 (hydroxyl value: 27 KOH mg/g), all of which are manufactured by Shin-Etsu Chemical Co., Ltd.; and the like.

Examples of the compound having at least two cyanate groups in one molecule thereof as the component (b), which is used for the production of the compatibilized resin (A1), include novolak type cyanate resins, bisphenol A type cyanate resins, bisphenol E type cyanate resins, bisphenol F type cyanate resins, tetramethyl bisphenol F type cyanate resins, and the like, and these resins can be used solely or in admixture of two or more kinds thereof. Of these, in view of dielectric characteristics, heat resistance, flame retardancy, low thermal expansion, and inexpensiveness, bisphenol A type cyanate resins and novolak type cyanate resins represented by the following general formula (III) are especially preferable. 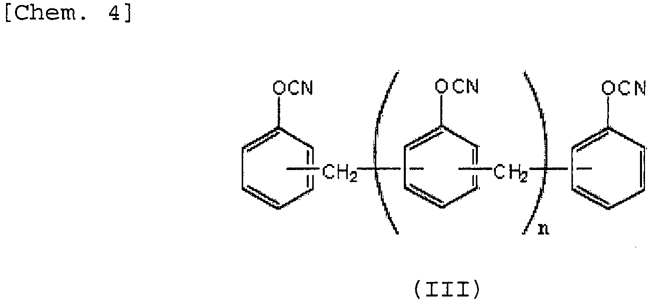 (n represents 0 or an integer of 1 or more.)

n in the foregoing general formula (III) is an average repeating number of the novolak type cyanate resin and is not particularly limited. However, n is preferably from 0.1 to 30 as an average value. When n is 0.1 or more, the matter that handling becomes difficult due to the generation of crystallization does not occur, whereas when n is not more than 30, a cured material does not become brittle.

Examples of the compound having at least two epoxy groups in one molecule thereof as the component (c), which is used for the production of the compatibilized resin (A1), include glycidyl ether based compounds, glycidyl amine based compounds, and glycidyl ester based compounds of a bisphenol A based compound, a bisphenol F based compound, a biphenyl based compound, a novolak based compound, a polyfunctional phenol based compound, a naphthalene based compound, an alicyclic compound, an alcohol based compound, etc.; and the like, and these compounds can be used solely or in admixture of two or more kinds thereof.

Of these, in view of high rigidity, dielectric characteristics, heat resistance, flame retardancy, moisture resistance, and low thermal expansion, naphthalene ring-containing epoxy resins such as naphthalene type epoxy resins, naphthol aralkyl type epoxy resins, dihydroxynaphthalene aralkyl type epoxy resins, naphthol aralkyl/cresol copolymer type epoxy resins, etc., and biphenyl group-containing epoxy resins such as biphenyl type epoxy resins, biphenyl aralkyl type epoxy resins, etc. are preferable; and in view of solubility in an aromatic organic solvent, naphthol aralkyl type epoxy resins, naphthol aralkyl/cresol copolymer type epoxy resins, and biphenyl type epoxy resins are more preferable; and a biphenyl type epoxy resin represented by the following formula (IV) is especially preferable because it is inexpensive and small in terms of an epoxy equivalent, and it is sufficiently blended in a small amount.

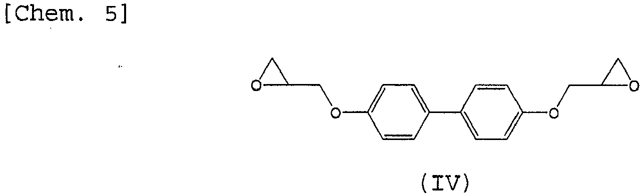

In the process for producing the compatibilized resin (A1), a raw material composition comprises from 10 to 50 parts by mass of the component (a), from 40 to 80 parts by mass of the component (b), and from 10 to 50 parts by mass of the component (c) based on 100 parts by mass of a total amount of the components (a) to (c), and these components are reacted in the presence of an organic metal salt (d) in a solvent selected among toluene, xylene, and mesitylene at from 80 to 120°C at a rate of reaction of the component (b) of from 30 to 70 % by mole.

The organic metal salt as the component (d) serves as a reaction catalyst, and examples thereof include zinc naphthenate, cobalt naphthenate, tin octylate, cobalt octylate, and the like. An amine based or imidazole based nitrogen atom-containing reaction catalyst is not preferable because a cured material of the resin obtained becomes brittle, and its heat resistance and adhesiveness are lowered.

That is, the process for producing the compatibilized resin (A1) according to the present invention is a process in which the components (a) to (c) are uniformly dissolved in advance in a solvent selected among toluene, xylene, and mesitylene and subjected to an iminocarbonation reaction and a triazine ring-forming reaction at a reaction temperature of from 80 to 120°C, thereby achieving a pre-reaction such that a rate of reaction of the cyanate group-containing compound (b) is from 30 to 70 % by mole.

Here, an aromatic solvent selected among toluene, xylene, and mesitylene is used as the reaction solvent. A small amount of other solvent may be used, if desired. However, according to other solvent, the desired reaction is not advanced, and heat resistance or the like is lowered. In addition, benzene is strong in terms of toxicity, whereas an aromatic solvent having a molecular weight larger than mesitylene is liable to become a remaining solvent at the time of production and coating of a prepreg, and therefore, these solvents are not preferable.

The raw material composition in the production of the compatibilized resin (A1) comprises from 10 to 50 parts by mass of the component (a), from 40 to 80 parts by mass of the component (b), and from 10 to 50 parts by mass of the component (c), and preferably from 10 to 30 parts by mass of the component (a), from 50 to 70 parts by mass of the component (b), and from 10 to 40 parts by mass of the component (c) based on 100 parts by mass of a total amount of the components (a) to (c). Here, when the proportion of the component (a) is less than 10 parts by mass, there may be the case where low thermal expansion in the surface direction of the obtained base material is lowered, whereas when the proportion of the component (a) is more than 50 parts by mass, there may be the case where heat resistance and chemical resistance are lowered. When the proportion of the component (b) is less than 40 parts by mass, there may be the case where compatibility of the obtained resin is lowered, whereas when the proportion of the component (b) is more than 80 parts by mass, there may be the case where low thermal expansion in the surface direction of the obtained base material is lowered. When the proportion of the component (c) is less than 10 parts by mass, there may be the case where moisture resistance and heat resistance are lowered, whereas when the proportion of the component (c) is more than 50 parts by mass, there may be the case where adhesiveness to copper foil and dielectric characteristics are lowered.

A use amount of the organic metal salt (d) is preferably from 0. 0001 to 0.004 parts by mass based on 100 parts by mass of a total amount of the components (a) to (c). When the use amount of the organic metal salt (d) is 0.0001 parts by mass or more, a desired reaction rate can be attained without requiring a long period of time for the reaction. In addition, when it is not more than 0.004 parts by mass, the matter that endpoint control becomes difficult due to excess of a reaction speed does not occur. Here, the rate of reaction of the cyanate group-containing compound (b) is determined by means of GPC measurement from a rate of disappearance of peak area by comparison between a peak area of the cyanate group-containing compound (b) at the time of start of the reaction and a peak area after the reaction for a prescribed period of time.

A reaction temperature of such a pre-reaction is from 80 to 120°C, and preferably from 100 to 110°C. When the reaction temperature is lower than 80°C, there may be the case where the production time (reaction time) becomes excessively long, whereas when it is higher than 120°C, there may be the case where gelation occurs because of the occurrence of a side reaction of the epoxy resin.

A rate of reaction of the pre-reaction is regulated to be from 30 to 70 % by mole, and preferably from 40 to 68 % by mole in terms of a rate of reaction (rate of disappearance) of the cyanate group-containing compound (b). When the rate of reaction is less than 30 % by mole, the obtained resin is not compatibilized, and the resin is separated and becomes cloudy, so that it may be impossible to produce a B-stage coated fabric. In addition, when the rate of reaction is more than 70 % by mole, there may be the case where the obtained thermosetting resin becomes insoluble in a solvent, so that it may be impossible to produce an A-stage varnish (thermosetting resin composition), or a gelling time of the prepreg becomes excessively short, so that moldability at the time of pressing is lowered.

The thermosetting resin composition (I) according to the present invention comprises the compatibilized resin (A1) produced by the foregoing process and (B) fused silica having been subjected to a surface treatment with a trimethoxysilane compound represented by the following formula (II).

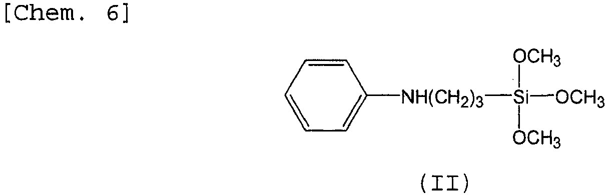

The surface-treated fused silica as the component (B) is obtained by subjecting fused silica to a surface treatment with a trimethoxysilane compound represented by the foregoing formula (II). The component (B) is, for example, obtained by adding and mixing fused silica in a ketone based organic solvent such as methyl ethyl ketone, methyl isobutyl ketone, cyclohexanone, etc. , or an alcohol based organic solvent such as ethylene glycol monomethyl ether, propylene glycol monomethyl ether, etc., thereafter, adding a trimethoxysilane compound represented by the foregoing formula (II), and then subjecting the contents to a surface treatment (wet treatment) while agitating at from 60 to 120°C for from about 0.5 to 5 hours. The fused silica is commercially available from Admatechs Company Limited, etc., and examples thereof include trade names: SC-2050KNK and SC-2050HNK, manufactured by Admatechs Company Limited, and the like.

A use amount of the fused silica as the component (B) is preferably from 10 to 300 parts by mass, more preferably from 100 to 250 parts by mass, and especially from 150 to 250 parts by mass based on 100 parts by mass of the compatibilized resin (A1) as reduced into a solid content. When the use amount of the fused silica as the component (B) is 10 parts by mass or more, rigidity of the base material, moisture resistance and heat resistance, and flame retardancy do not become insufficient, whereas when it is not more than 300 parts by mass, moldability and chemical resistance such as plating solution resistance, etc. are not lowered.

The thermosetting resin composition (II) according to the present invention is a thermosetting resin composition comprising (A2) a thermosetting resin and (B) fused silica having been subjected to a surface treatment with a trimethoxysilane compound represented by the formula (II), wherein
the thermosetting resin (A2) is a resin obtained by reacting (a) a siloxane resin having a hydroxyl group at an end thereof, which is represented by the following general formula (I), and (b) a compound having at least two or more cyanate groups in one molecule thereof in an organic solvent,
from 10 to 70 parts by mass of the siloxane resin (a) and from 30 to 90 parts by mass of the compound (b) are contained based on 100 parts by mass of a total sum of the siloxane resin (a) and the compound (b), and
a rate of reaction of the compound (b) is from 40 to 70 % by mole.

As the siloxane resin (a) having a hydroxyl group at an end thereof, the compound (b) having at least two or more cyanate groups in one molecule thereof, and the organic solvent, all of which are used for the thermosetting resin (A2), the same materials as those used for the production of the compatibilized resin (A1) as described above are useful.

In addition, as the fused silica (B) which is used for the thermosetting resin composition (II), the same material as that used for the thermosetting resin composition (I) is useful.

A blending amount of the siloxane resin (a) and the compound (b) used for the thermosetting resin (A2) is preferably set as follows.

That is, a blending amount of the siloxane resin (a) is set in the range of from 10 to 70 parts by mass based on 100 parts by mass of a total sum of the siloxane resin (a) and the compound (b). In addition, a blending amount of the compound (b) is set in the range of from 30 to 90 parts by mass.

When the blending amount of the siloxane resin (a) is in the range of from 10 to 70 parts by mass, sufficient low thermal expansion in the surface direction of the base material which is coated with the thermosetting resin (A) is obtained. In addition, when the blending amount of the siloxane resin (a) is in the range of from 10 to 70 parts by mass, sufficient heat resistance and chemical resistance can be obtained. In addition, when the blending amount of the compound (b) is in the range of from 30 to 90 parts by mass, sufficient low thermal expansion in the surface direction of the base material obtained using the thermosetting resin (A) is obtained. In addition, sufficient heat resistance is obtained.

In addition, in the thermosetting resin (A2), it is preferable to subject the siloxane resin (a) and the compound (b) to a pre-reaction in advance in an organic solvent such that a rate of reaction (rate of disappearance) of the compound (b) is from 40 to 70 % by mole. Examples of the pre-reaction include the foregoing iminocarbonation reaction and triazine ring-forming reaction.

When the rate of reaction of the compound (b) is from 40 to 70 % by mole, compatibility of the thermosetting resin (A2) obtained by reacting the siloxane resin (a) and the compound (b) with a general-purpose organic solvent is good, and sufficient curing properties are obtained, and therefore, the heat resistance of the obtained thermosetting resin (A2) can be increased. When the rate of reaction of the compound (b) falls within the foregoing range, adhesiveness to copper foil is good. In addition, when the rate of reaction of the compound (b) falls within the foregoing range, the thermosetting resin (A) is hardly crystallized, a varnish is easily prepared, and moldability is good. In addition, the generation of tack can be reduced in a state where glass fibers or the like is impregnated in a solution of the thermosetting resin (A) and semi-cured (so-called B-stage state).

Incidentally, a rate of reaction of the compound (b) is determined from the measurement result by means of GPC measurement. Specifically, a peak area of the cyanate resin appearing in the vicinity of a prescribed retention time is compared between a solution having the siloxane resin (a) and the compound (b) blended therein before the reaction and a solution after allowing this solution to react. A rate of disappearance of a peak area of the solution after the reaction to a peak area of the solution before the reaction is corresponding to the rate of reaction.

A blending amount of the fused silica (B) in the thermosetting resin composition (II) is preferably set to from 10 to 300 parts by mass, more preferably from 100 to 250 parts by mass, and especially preferably from 150 to 250 parts by mass based on 100 parts by mass of the thermosetting resin (A) as reduced into a solid content. When the blending amount of the fused silica (B) is from 10 to 300 parts by mass, sufficient rigidity of the base material, moisture resistance and heat resistance, flame retardancy, and resistance to corrosion with a plating solution, and the like are obtained.

In the thermosetting resin composition (I) and the thermosetting resin composition (II) (hereinafter also referred to as "thermosetting resin composition according to the present invention" as a general term), an inorganic filler (C) other than the component (B) may be used. Examples of the inorganic filler (C) include pulverized silica, mica, talc, glass short fiber or fine powder, hollow glass, calcium carbonate, quartz powder, metal hydrates, and the like. Of these, in view of low thermal expansion, high elasticity, heat resistance, and flame retardancy, metal hydrates such as aluminum hydroxide, magnesium hydroxide, etc. are preferable. Furthermore, among metal hydrates, in view of the fact that high heat resistance and flame retardancy are compatible with each, metal hydrates having a thermal decomposition temperature of 300°C or higher, compounds obtained by adjusting, for example, boehmite type aluminum hydroxide (A100H) or gibbsite type aluminum hydroxide (Al (OH)₃) so as to have a thermal decomposition temperature of 300°C or high by means of a heat treatment, magnesium hydroxide, and the like are more preferable. In particular, boehmite type aluminum hydroxide (AlOOH) which is inexpensive and has an especially high thermal decomposition temperature of 350°C or higher and high chemical resistance is especially preferable.

A use amount of the inorganic filler (C) in the thermosetting resin composition (I) is preferably from 0 to 200 parts by mass, more preferably from 10 to 150 parts by mass, and especially preferably from 50 to 150 parts by mass based on 100 parts by mass of the compatibilized resin (A1) as reduced into a solid content. When the use amount of the inorganic filler (C) is 10 parts by mass or more, flame retardancy does not become insufficient, whereas when it is not more than 200 parts by mass, chemical resistance such as plating solution resistance, etc. and moldability are not lowered.

A use amount of the inorganic filler (C) in the thermosetting resin composition (II) is preferably from 10 to 200 parts by mass, more preferably from 10 to 150 parts by mass, and especially preferably from 50 to 150 parts by mass based on 100 parts by mass of the thermosetting resin (A2) as reduced into a solid content. When the use amount of the inorganic filler (C) is in the range of from 10 to 200 parts by mass, sufficient flame retardancy, resistance to corrosion with a plating solution, and moldability are obtained.

In the thermosetting resin composition according to the present invention, it is desirable to use a curing accelerator for the purpose of enhancing heat resistance, flame retardancy, adhesiveness to copper foil, and the like. Examples of the curing accelerator include organic metal salts such as zinc naphthenate, cobalt naphthenate, tin octylate, cobalt octylate, etc., imidazoles and derivatives thereof, tertiary amines, quaternary ammonium salts, and the like. By using the curing accelerator, heat resistance, flame retardancy, adhesiveness to copper foil, and the like do not become insufficient.

In the thermosetting resin composition according to the present invention, (D) an inorganic flame retardant assistant other than the components (B) and (C) can be arbitrarily used in combination. But, a halogen-containing flame retarder containing bromine or chlorine, a metal hydroxide having a thermal decomposition temperature of lower than 300°C, and the like are unsuitable for the object of the present invention.

Examples of the inorganic flame retardant assistant (D) include phosphorus based flame retarders such as triphenyl phosphate, tricresyl phosphate, trisdichloropropyl phosphate, phosphate based compounds, phosphazene, red phosphorus, etc.; inorganic flame retardant assistants such as antimony trioxide, zinc molybdate, etc.; and the like. In particular, an inorganic flame retardant assistant having zinc molybdate carried on an inorganic filler such as talc, etc. is an especially preferred inorganic flame retardant assistant because it remarkably enhances not only flame retardancy but drillability. A use amount of zinc molybdate is preferably from 5 to 20 parts by mass based on 100 parts by mass of the compatibilized resin (A1) or the thermosetting resin (A2). When the use amount of zinc molybdate is 5 parts by mass or more, flame retardancy and drillability are enhanced, whereas when it is not more than 20 parts by mass, the matter that a gelling time of a varnish is excessively short so that at the time of molding a laminate by means of pressing, moldability is lowered does not occur.

In the thermosetting resin composition according to the present invention, known thermoplastic resin, elastomer, flame retarder, and organic filler can be arbitrarily contained.

Examples of the thermoplastic resin include polytetrafluoroethylene, polyethylene, polypropylene, polystyrene, polyphenylene ether resins, phenoxy resins, polycarbonate resins, polyester resins, polyamide resins, polyimide resins, xylene resins, petroleum resins, silicone resins, and the like.

Examples of the elastomer include polybutadiene, ABS resins, epoxy-modified polybutadiene, maleic anhydride-modified polybutadiene, phenol-modified polybutadiene, carboxy-modified acrylonitrile, and the like.

Examples of the flame retarder include those described above for the inorganic filler (C).

Examples of the organic filler include organic material powders such as silicone powder, polytetrafluoroethylene, polyethylene, polypropylene, polystyrene, polyphenylene ether, etc., and the like.

In the present invention, an ultraviolet light absorber, an antioxidant, a photopolymerization initiator, a fluorescent brightener, an adhesion improver, and the like can also be arbitrarily added to the thermosetting resin composition according to the present invention without particular limitations. Examples thereof include ultraviolet light absorbers such as benzotriazole based ultraviolet light absorbers, etc.; antioxidants such as hindered phenol based antioxidants, styrenated phenol, etc.; photopolymerization initiators such as benzophenones, benzyl ketals, thioxanthone based photopolymerization initiators, etc.; fluorescent brighteners such as stilbene derivatives, etc.; adhesion improvers such as urea compounds, e.g., urea silane, etc., silane coupling agents, etc.; and the like.

The prepreg according to the present invention is a prepreg obtained by impregnating or coating a base material with the foregoing thermosetting resin composition according to the present invention and then bringing it into a B-stage. The prepreg according to the present invention is hereunder described in detail.

That is, the prepreg according to the present invention can be produced by impregnating or coating a base material with the thermosetting resin composition according to the present invention and then semi-curing it (bringing it into a B-stage) by means of heating or the like.

For the base material which is used for the prepreg, well-known base materials which are used for various laminates for electrical insulating material can be used. Examples of a material quality thereof include inorganic material fibers such as E-glass, D-glass, S-glass, Q-glass, etc.; organic fibers such as polyimides, polyesters, tetrafluoroethylene, etc.; mixtures thereof; and the like. Such a base material has a shape, for example, a woven fabric, a nonwoven fabric, a roving, a chopped strand mat, a surfacing mat, etc. However, the material quality and shape are chosen depending upon an application and a performance of the desired molded article, and if desired, the material quality and shape can be adopted solely or in combination of two or more kinds thereof.

A thickness of the base material is not particularly limited, and for example, a base material having a thickness of from about 0.03 to 0. 5 mm can be used. A base material having been subjected to a surface treatment with a silane coupling agent or the like, or a base material having been subjected to a mechanical opening treatment is suitable in view of heat resistance, moisture resistance, and processability.

The prepreg according to the present invention can be obtained by impregnating or coating a base material with the thermosetting resin composition in such a manner that a coverage of the thermosetting resin composition is from 20 to 90 % by mass relative to the base material in terms of a resin content of the prepreg after drying and thereafter, usually heat-drying at a temperature of from 100 to 200°C for from 1 to 30 minutes, thereby semi-curing it (bringing it into a B-stage).

The laminate according to the present invention is a laminate formed using the prepreg according to the present invention, and it can be formed by using the foregoing prepreg and subjecting it to laminate molding.

That is, the laminate according to the present invention can be produced by, for example, superimposing from 1 to 20 sheets of the foregoing prepreg and subjecting the superimposed material to laminate molding in a configuration in which a metal foil such as copper, aluminum, etc. is disposed on one surface or both surfaces thereof. The metal foil is not particularly limited so far as it is used for an application of electrical insulating material.

In addition, as for a molding condition, for example, techniques for laminates and multilayer boards for electrical insulating material can be applied. For example, molding can be performed at a temperature ranging from 100 to 250°C and a pressure ranging from 2 to 100 kg/cm² (0.2 to 10 MPa) for a heating time ranging from 0.1 to 5 hours by using a multi-stage press, a multi-stage vacuum press, a continuous molding machine, an autoclave molding machine, or the like. In addition, a multilayer board can also be produced by combining the prepreg according to the present invention with a wiring board for internal layer and subjecting to laminate molding.

### [Examples]

Next, the present invention is described in more detail with reference to the following Examples, but it should be construed that these Examples do not limit the present invention in any sense.

Incidentally, copper clad laminates obtained in the following Examples and Comparative Examples were measured and evaluated in the following methods.
(1) Adhesiveness to copper foil (copper foil peel strength) :
   The copper clad laminate wad dipped in a copper etching solution to form a copper foil having a width of 1 cm, thereby fabricating an evaluation substrate. The evaluation substrate was measured for adhesiveness to copper foil (peel strength) by using a tensile tester.
(2) Glass transition temperature (Tg):
   The copper clad laminate was dipped in a copper etching solution to remove the copper foil, thereby fabricating an evaluation substrate of 5 mm square. The evaluation substrate was evaluated by observing thermal expansion characteristics in the surface direction thereof by using a TMA tester (TMA 2940, manufactured by DuPont).
(3) Solder heat resistance:
   The copper clad laminate was dipped in a copper etching solution to remove the copper foil, thereby fabricating an evaluation substrate of 5 mm square. The evaluation substrate was subjected to a pressure cooker treatment under a condition at 121°C and 2 atms for at most 4 hours by using a pressure cooker tester, manufactured by Hirayama Manufacturing Corporation, and thereafter, the evaluation substrate was dipped in a solder bath at a temperature of 288°C for 20 seconds and then evaluated for solder heat resistance by observing an appearance thereof.
(4) Coefficient of linear thermal expansion:
   The copper clad laminate was dipped in a copper etching solution to remove the copper foil, thereby fabricating an evaluation substrate of 5 mm square. The evaluation substrate was measured for a coefficient of linear thermal expansion at from 30°C to 100°C in the surface direction thereof by using a TMA tester (TMA 2940, manufactured by DuPont).
(5) Flame retardancy:
   The copper clad laminate was dipped in a copper etching solution to remove the copper foil, thereby fabricating an evaluation substrate of 5 mm square. The evaluation substrate was then cut out into a size of 127 mm in length and 12.7 mm in width, thereby fabricating a test piece. The test piece was evaluated in conformity with the test method (V method) of UL94.
(6) Copper-clad heat resistance (T-300):
   An evaluation substrate of 5 mm square was fabricated from the copper clad laminate and then evaluated for copper-clad heat resistance by measuring a time until expansion of the evaluation substrate generates at 300°C.
(7) Dielectric characteristics (relative dielectric constant and dielectric tangent):
   The obtained copper clad laminate was dipped in a copper etching solution to remove the copper foil, thereby fabricating an evaluation substrate of 5 mm square. The evaluation substrate was measured for relative dielectric constant and dielectric tangent at a frequency of 1 GHz by using a relative dielectric constant measuring device, manufactured by Hewlett-Packard Company (a product name: HP4291B).
(8) Drillability:
   An evaluation substrate was fabricated by using a drill having a diameter of 0.105 mm (Union Tool NV J676) and drilling at a rotation rate of 160, 000 rpm and a feed speed of 0.8 m/min in a pile up number of 1 while hitting 6, 000 times, and a hole wall roughness of a drill hole was evaluated. The hole wall roughness was evaluated by performing electroless copper plating (plating thickness: 15 µm) and measuring a maximum value of a plating permeation depth into the hole wall.

### Production Example 1: Production of compatibilized resin (A1-1)

In a reaction vessel having a capacity of 3 liters, which was capable of being heated and cooled and which was equipped with a thermometer, an agitator, and a reflux condenser, 600. 0 g of a bisphenol A type cyanate resin (a trade name: Primaset BADCy, manufactured by Lonza Japan Ltd.), 200.0 g of a siloxane resin represented by the following formula (V) (a trade name: X-22-1821, manufactured by Shin-Etsu Chemical Co., Ltd., hydroxyl equivalent: 1,600), 200.0 g of a biphenyl type epoxy resin (a trade name: YX-4000, manufactured by Japan Epoxy Resin Co., Ltd., epoxy equivalent: 186), and 1,000.0 g of toluene were charged. Subsequently, the temperature was increased to 120°C while agitating, and after confirming that the resin solids were dissolved to form a uniform solution, 0.01 g of an 8 % by mass mineral spirit solution of zinc naphthenate was added, followed by performing a reaction at about 110°C for 4 hours. Thereafter, the reaction mixture was cooled to room temperature, thereby obtaining a solution of a compatibilized resin (A1-1).

A small amount of this reaction solution was taken out and subjected to GPC measurement (as reduced into polystyrene, eluant: tetrahydrofuran) . As a result, in comparison of a peak area of the bisphenol A type cyanate resin as a synthetic raw material appearing in the vicinity of about 12.4 minutes of an elution time with a peak area of the bisphenol A type cyanate resin at the time of start of the reaction, a rate of disappearance of peak area [rate of reaction of the component (b)] was 68 %. In addition, peaks of a product of the thermosetting resin appearing in the vicinity of about 10.9 minutes and in the vicinity of from 8.0 to 10.0 were confirmed. Furthermore, a small amount of the reaction solution as taken out was added dropwise to a mixed solvent of methanol and benzene (mixing weight ratio: 1/1) to cause reprecipitation, and the thus purified solid was taken out and subjected to FT-IR measurement. As a result, a peak caused due to an iminocarbonate group in the vicinity of 1,700 cm⁻¹ and strong peaks caused due to a triazine ring in the vicinity of 1,560 cm⁻¹ and in the vicinity of 1,380 cm⁻¹ could be confirmed, and thus, it was confirmed that the compatibilized resin (A1-1) was produced. 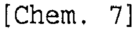 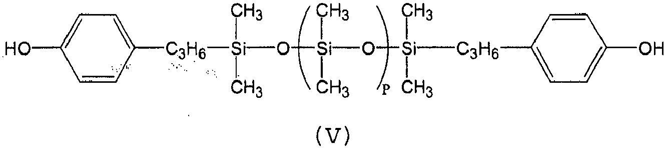 (In the formula, p is a number of from 35 to 40 as an average value.)

### Production Example 2: Production of compatibilized resin (A1-2)

In a reaction vessel having a capacity of 3 liters, which was capable of being heated and cooled and which was equipped with a thermometer, an agitator, and a reflux condenser, 800.0 g of a novolak type cyanate resin (a trade name: Primaset PT-15, manufactured by Lonza Japan Ltd., mass average molecular weight: 500 to 1,000) , 100.0g of a siloxane resin represented by the following formula (VI) (a trade name: KF-6003, manufactured by Shin-Etsu Chemical Co., Ltd., hydroxyl equivalent: 2,800), 100.0 g of a naphthol aralkyl/cresol copolymer type epoxy resin (a trade name: NC-7000L, manufactured by Nippon Kayaku Co., Ltd., epoxy equivalent: 230), and 1,000.0 g of toluene were charged. Subsequently, the temperature was increased to 120°C while agitating, and after confirming that the resin solids were dissolved to form a uniform solution, 0.01 g of an 8 % by mass mineral spirit solution of zinc naphthenate was added, followed by performing a reaction at about 110°C for 4 hours. Thereafter, the reaction mixture was cooled to room temperature, thereby obtaining a solution of a compatibilized resin (A-2).

A small amount of this reaction solution was taken out and subjected to GPC measurement (as reduced into polystyrene, eluant: tetrahydrofuran) . As a result, in comparison of a peak area of the novolak type cyanate resin as a synthetic raw material appearing in the vicinity of about 12.1 minutes of an elution time with a peak area of the novolak type cyanate resin at the time of start of the reaction, a rate of disappearance of peak area [rate of reaction of the component (b)] was 43 %. In addition, peaks of a product of the thermosetting resin appearing in the vicinity of about 10.9 minutes and in the vicinity of from 8.0 to 10. 0 were confirmed. Furthermore, a small amount of the reaction solution as taken out was added dropwise to a mixed solvent of methanol and benzene (mixing weight ratio: 1/1) to cause reprecipitation, and the thus purified solid was taken out and subjected to FT-IR measurement. As a result, a peak caused due to an iminocarbonate group in the vicinity of 1,700 cm⁻¹ and strong peaks caused due to a triazine ring in the vicinity of 1,560 cm⁻¹ and in the vicinity of 1,380 cm⁻¹ could be confirmed, and thus, it was confirmed that the compatibilized resin (A1-2) was produced. 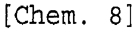 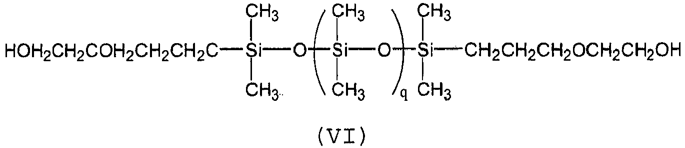 (In the formula, q is a number of from 70 to 75 as an average value.)

### Production Example 3: Production of compatibilized resin (A1-3)

In a reaction vessel having a capacity of 3 liters, which was capable of being heated and cooled and which was equipped with a thermometer, an agitator, and a reflux condenser, 400.0 g of a dicyclopentadiene type cyanate resin (a trade name: Primaset DT-4000, manufactured by Lonza Japan Ltd., mass average molecular weight: 500 to 1,000), 100. 0 g of a siloxane resin represented by the following formula (VII) (a trade name: X-22-160AS, manufactured by Shin-Etsu Chemical Co., Ltd., hydroxyl equivalent: 500), 500.0 g of a biphenyl aralkyl type epoxy resin (a trade name: NC-3000H, manufactured by Nippon Kayaku Co., Ltd., epoxy equivalent: 280), and 1,000.0 g of mesitylene were charged.

Subsequently, the temperature was increased to 120°C while agitating, and after confirming that the resin solids were dissolved to form a uniform solution, 0.30 g of an 8 % by mass mineral spirit solution of zinc naphthenate was added, followed by performing a reaction at about 110°C for 4 hours. Thereafter, the reaction mixture was cooled to room temperature, thereby obtaining a solution of a compatibilized resin (A1-3).

A small amount of this reaction solution was taken out and subjected to GPC measurement (as reduced into polystyrene, eluant: tetrahydrofuran) . As a result, in comparison of a peak area of the novolak type cyanate resin as a synthetic raw material appearing in the vicinity of about 12.0 minutes of an elution time with a peak area of the novolak type cyanate resin at the time of start of the reaction, a rate of disappearance of peak area [rate of reaction of the component (b)] was 43 %. In addition, peaks of a product of the thermosetting resin appearing in the vicinity of about 10.9 minutes and in the vicinity of from 8. 0 to 10.0 were confirmed. Furthermore, a small amount of the reaction solution as taken out was added dropwise to a mixed solvent of methanol and benzene (mixing mass ratio: 1/1) to cause reprecipitation, and the thus purified solid was taken out and subjected to FT-IR measurement. As a result, a peak caused due to an iminocarbonate group in the vicinity of 1, 700 cm⁻¹ and strong peaks caused due to a triazine ring in the vicinity of 1,560 cm-¹ and in the vicinity of 1,380 cm⁻¹ could be confirmed, and thus, it was confirmed that the compatibilized resin (A1-3) was produced. 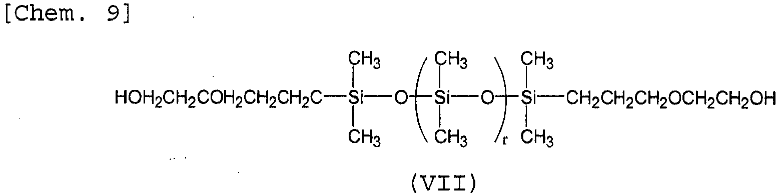 (In the formula, r is a number of from 10 to 15 as an average value.)

### Production Example 4: Production of compatibilized resin (A1-4)

In a reaction vessel having a capacity of 3 liters, which was capable of being heated and cooled and which was equipped with a thermometer, an agitator, and a reflux condenser, 400. 0 g of a bisphenol A type cyanate resin (a trade name: Primaset BADCy, manufactured by Lonza Japan Ltd.), 500 . 0 g of a siloxane resin represented by the foregoing formula (V) (a trade name: X-22-1821, manufactured by Shin-Etsu Chemical Co., Ltd., hydroxyl equivalent: 1,600), 100.0 g of a naphthalene type epoxy resin (a trade name: EPICLON HP-4032, manufactured by DIC Corporation, epoxy equivalent: 150), and 1,000.0 g of toluene were charged. Subsequently, the temperature was increased to 120°C while agitating, and after confirming that the resin solids were dissolved to form a uniform solution, 0.01 g of an 8 % by mass mineral spirit solution of zinc naphthenate was added, followed by performing a reaction at about 110°C for 4 hours. Thereafter, the reaction mixture was cooled to room temperature, thereby obtaining a solution of a compatibilized resin (A1-4).

A small amount of this reaction solution was taken out and subjected to GPC measurement (as reduced into polystyrene, eluant: tetrahydrofuran) . As a result, in comparison of a peak area of the bisphenol A type cyanate resin as a synthetic raw material appearing in the vicinity of about 12.4 minutes of an elution time with a peak area of the bisphenol A type cyanate resin at the time of start of the reaction, a rate of disappearance of peak area [rate of reaction of the component (b)] was 55 %. In addition, peaks of a product of the thermosetting resin appearing in the vicinity of about 10.9 minutes and in the vicinity of from 8.0 to 10.0 were confirmed. Furthermore, a small amount of the reaction solution as taken out was added dropwise to a mixed solvent of methanol and benzene (mixing weight ratio: 1/1) to cause reprecipitation, and the thus purified solid was taken out and subjected to FT-IR measurement. As a result, a peak caused due to an iminocarbonate group in the vicinity of 1,700 cm⁻¹ and strong peaks caused due to a triazine ring in the vicinity of 1,560 cm⁻¹ and in the vicinity of 1,380 cm⁻¹ could be confirmed, and thus, it was confirmed that the compatibilized resin (A1-4) was produced.

### Production Example 5: Production of fused silica (B-1) having been subjected to a surface treatment with a trimethoxysilane compound

In a reaction vessel having a capacity of 3 liters, which was capable of being heated and cooled and which was equipped with a thermometer, an agitator, and a reflux condenser, 700.0 g of fused silica (a trade name: SO-25R, manufactured by Admatechs Company Limited) and 1,000.0 g of propylene glycol monomethyl ether were blended, and 7.0 g of N-phenyl-3-aminopropyltrimethoxysilane (a trade name: KBM-573, manufactured by Shin-Etsu Chemical Co., Ltd.) was added while agitating. Subsequently, the temperature was increased to 80°C, and the contents were reacted at 80°C for one hour, thereby subjecting the fused silica to a surface treatment (wet treatment). Thereafter, the reaction mixture was cooled to room temperature, thereby obtaining a solution of fused silica (B-1) having been subjected to a surface treatment (wet treatment) with N-phenyl-3-aminopropyltrimethoxysilane.

### Comparative Production Example 1: Production of resin (A1-5) (rate of reaction of component (b): 18 %)

In a reaction vessel having a capacity of 3 liters, which was capable of being heated and cooled and which was equipped with a thermometer, an agitator, and a reflux condenser, 600.0 g of a bisphenol A type cyanate resin (a trade name: Primaset BADCy, manufactured by Lonza Japan Ltd.), 200. 0 g of a siloxane resin represented by the foregoing formula (V) (a trade name: X-22-1821, manufactured by Shin-Etsu Chemical Co., Ltd., hydroxyl equivalent: 1,600), 200.0 g of a biphenyl type epoxy resin (a trade name: YX-4000, manufactured by Japan Epoxy Resin Co., Ltd., epoxy equivalent: 186), and 1,000.0 g of toluene were charged. Subsequently, the temperature was increased to 120°C while agitating, and after confirming that the resin solids were dissolved to form a uniform solution, 0.01 g of an 8 % by mass mineral spirit solution of zinc naphthenate was added, followed by performing a reaction at about 110°C for one hour. Thereafter, the reaction mixture was cooled to room temperature, thereby obtaining a solution of a resin (A1-5).

A small amount of this reaction solution was taken out and subjected to GPC measurement (as reduced into polystyrene, eluant: tetrahydrofuran) . As a result, in comparison of a peak area of the bisphenol A type cyanate resin as a synthetic raw material appearing in the vicinity of about 12.4 minutes of an elution time with a peak area of the bisphenol A type cyanate resin at the time of start of the reaction, a rate of disappearance of peak area [rate of reaction of the component (b)] was 18 %. In addition, in this solution, a precipitate was formed due to crystallization on the next day.

### Comparative Production Example 2: Production of resin (A1-6) (rate of reaction of component (b): 76 %)

In a reaction vessel having a capacity of 3 liters, which was capable of being heated and cooled and which was equipped with a thermometer, an agitator, and a reflux condenser, 600.0 g of a bisphenol A type cyanate resin (a trade name: Primaset BADCy, manufactured by Lonza Japan Ltd.), 200.0 g of a siloxane resin represented by the foregoing formula (V) (a trade name: X-22-1821, manufactured by Shin-Etsu Chemical Co., Ltd., hydroxyl equivalent: 1,600), 200.0 g of a biphenyl type epoxy resin (a trade name: YX-4000, manufactured by Japan Epoxy Resin Co., Ltd., epoxy equivalent: 186), and 1,000.0 g of toluene were charged. Subsequently, the temperature was increased to 120°C while agitating, and after confirming that the resin solids were dissolved to form a uniform solution, 0.01 g of an 8 % by mass mineral spirit solution of zinc naphthenate was added, followed by performing a reaction at about 120°C for 6 hours. Thereafter, the reaction mixture was cooled to room temperature, thereby obtaining a solution of a resin (A1-6).

A small amount of this reaction solution was taken out and subjected to GPC measurement (as reduced into polystyrene, eluant: tetrahydrofuran) . As a result, in comparison of a peak area of the bisphenol A type cyanate resin as a synthetic raw material appearing in the vicinity of about 12.4 minutes of an elution time with a peak area of the bisphenol A type cyanate resin at the time of start of the reaction, a rate of disappearance of peak area [rate of reaction of the component (b)] was 76 %.

### Comparative Production Example 3: Production of resin (A1-7) (rate of reaction of component (b): 53 %, free from the component (c))

In a reaction vessel having a capacity of 2 liters, which was capable of being heated and cooled and which was equipped with a thermometer, an agitator, and a reflux condenser, 600.0 g of a bisphenol A type cyanate resin (a trade name: Primaset BADCy, manufactured by Lonza Japan Ltd.), 200. 0 g of a siloxane resin represented by the foregoing formula (V) (a trade name: X-22-1821, manufactured by Shin-Etsu Chemical Co., Ltd., hydroxyl equivalent: 1,600), and 800.0 g of toluene were charged. Subsequently, the temperature was increased to 120°C while agitating, and after confirming that the resin solids were dissolved to form a uniform solution, 0.01 g of an 8 % by mass mineral spirit solution of zinc naphthenate was added, followed by performing a reaction at about 110°C for 4 hours. Thereafter, the reaction mixture was cooled to room temperature, thereby obtaining a solution of a resin (A1-7).

A small amount of this reaction solution was taken out and subjected to GPC measurement (as reduced into polystyrene, eluant: tetrahydrofuran) . As a result, in comparison of a peak area of the bisphenol A type cyanate resin as a synthetic raw material appearing in the vicinity of about 12.4 minutes of an elution time with a peak area of the bisphenol A type cyanate resin at the time of start of the reaction, a rate of disappearance of peak area [rate of reaction of the component (b)] was 53 %.

### Production Example 6: Production of thermosetting resin (A2-1)

In a reaction vessel having a capacity of 3 liters, which was capable of being heated and cooled and which was equipped with a thermometer, an agitator, and a reflux condenser, 500 g of a siloxane resin represented by the foregoing formula (V) (a trade name: X-22-1821, manufactured by Shin-Etsu Chemical Co., Ltd., hydroxyl equivalent: 1,600 g/eq) as the siloxane resin (a), 1, 000 g toluene, and 500 of a bisphenol A type cyanate resin (a trade name: Arocy B-10, manufactured by Lonza Japan Ltd.) as the compound (b) were blended, and the temperature was increased while agitating. After reaching 120°C, 0.01 g of an 8 % by mass mineral spirit solution of zinc naphthenate was added, and the contents were subjected to a reflux reaction at from about 115 to 125°C for 4 hours. Thereafter, the reaction mixture was cooled to room temperature (25°C), thereby obtaining a solution of a thermosetting resin (A2-1).

A small amount of each of the solution having the siloxane resin (a) and the compound (b) blended therein before the reaction and the solution after the reaction was taken out and subjected to GPC measurement (as reduced into polystyrene, eluant: tetrahydrofuran) . A peak area of the bisphenol A type cyanate resin appearing in the vicinity of about 12.4 minutes of a retention time was compared between the solution before the reaction and the solution after the reaction, and a rate of disappearance of the peak area of the solution after the reaction relative to the peak area of the solution before the reaction was calculated. As a result, the rate of disappearance of the peak area in the solution after the reaction was 65 %. Accordingly, a rate of reaction of the compound (b) in the thermosetting resin (A-1) was 65 % by mole. In addition, peaks of a product of the thermosetting resin appearing in the vicinity of about 10.9 minutes and in the vicinity of from 8.0 to 10.0 were confirmed. Furthermore, a small amount of the reaction solution as taken out was added dropwise to a mixed solvent of methanol and benzene (mixing mass ratio: 1/1) to cause reprecipitation, and the thus purified solid was taken out and subj ected to FT-IR measurement . As a result, a peak caused due to an iminocarbonate group in the vicinity of 1,700 cm⁻¹ and strong peaks caused due to a triazine ring in the vicinity of 1,560 cm⁻¹ and in the vicinity of 1,380 cm⁻¹ could be confirmed, and thus, it was confirmed that the thermosetting resin (A2-1) was produced.

### Production Example 7: Production of thermosetting resin (A2-2)

In a reaction vessel having a capacity of 3 liters, which was capable of being heated and cooled and which was equipped with a thermometer, an agitator, and a reflux condenser, 800 g of a novolak type cyanate resin (a trade name: Primaset PT-30, manufactured by Lonza Japan Ltd., weight average molecular weight: 500 to 1, 000) as the compound (b), 200 g of a siloxane resin represented by the foregoing formula (VI) (a trade name: KF-6003, manufactured by Shin-Etsu Chemical Co., Ltd., hydroxyl equivalent: 2,800 g/eq.) as the siloxane resin (a), and 1,000 g toluene were blended, and the temperature was increased while agitating. After reaching 120°C, 0.01 g of an 8 % by mass mineral spirit solution of zinc naphthenate was added, and the contents were subjected to a reflux reaction at from about 115 to 125°C for 4 hours. Thereafter, the reaction mixture was cooled to room temperature (25°C), thereby obtaining a solution of a thermosetting resin (A2-2).

A small amount of each of the solution having the siloxane resin (a) and the compound (b) blended therein before the reaction and the solution after the reaction was taken out and subjected to GPC measurement (as reduced into polystyrene, eluant: tetrahydrofuran) . A peak area of the bisphenol A type cyanate resin appearing in the vicinity of about 12.1 minutes of a retention time was compared between the solution before the reaction and the solution after the reaction, and a rate of disappearance of the peak area of the solution after the reaction relative to the peak area of the solution before the reaction was calculated. As a result, the rate of disappearance of the peak area in the solution after the reaction was 43 %. Accordingly, a rate of reaction of the compound (b) in the thermosetting resin (A2-2) was 43 % by mole. In addition, peaks of a product of the thermosetting resin appearing in the vicinity of about 10.9 minutes and in the vicinity of from 8.0 to 10.0 were confirmed. Furthermore, a small amount of the reaction solution as taken out was added dropwise to a mixed solvent of methanol and benzene (mixing mass ratio: 1/1) to cause reprecipitation, and the thus purified solid was taken out and subjected to FT-IR measurement. As a result, a peak caused due to an iminocarbonate group in the vicinity of 1,700 cm⁻¹ and strong peaks caused due to a triazine ring in the vicinity of 1, 560 cm⁻¹ and in the vicinity of 1,380 cm⁻¹ could be confirmed, and thus, it was confirmed that the thermosetting resin (A2-2) was produced.

### Production Example 8: Production of thermosetting resin (A2-3)

In a reaction vessel having a capacity of 3 liters, which was capable of being heated and cooled and which was equipped with a thermometer, an agitator, and a reflux condenser, 300 g of a novolak type cyanate resin (a trade name: Primaset PT-60, manufactured by Lonza Japan Ltd., weight average molecular weight: 2, 000 to 3,000) as the compound (b), 700 g of a siloxane resin represented by the foregoing formula (VII) (a trade name: X-22-160AS, manufactured by Shin-Etsu Chemical Co., Ltd., hydroxyl equivalent: 500 g/eq.) as the siloxane resin (a), and 1,000 g mesitylene were blended, and the temperature was increased while agitating. After reaching 120°C, 0.30 g of an 8 % by mass mineral spirit solution of zinc naphthenate was added, and the contents were subjected to a reflux reaction at from about 115 to 125°C for 4 hours. Thereafter, the reaction mixture was cooled to room temperature (25°C), thereby obtaining a solution of a thermosetting resin (A2-3).

A small amount of each of the solution having the siloxane resin (a) and the compound (b) blended therein before the reaction and the solution after the reaction was taken out and subjected to GPC measurement (as reduced into polystyrene, eluant: tetrahydrofuran) . A peak area of the bisphenol A type cyanate resin appearing in the vicinity of about 12.0 minutes of a retention time was compared between the solution before the reaction and the solution after the reaction, and a rate of disappearance of the peak area of the solution after the reaction relative to the peak area of the solution before the reaction was calculated. As a result, the rate of disappearance of the peak area in the solution after the reaction was 43 %. Accordingly, a rate of reaction of the compound (b) in the thermosetting resin (A2-3) was 43 % by mole. In addition, peaks of a product of the thermosetting resin appearing in the vicinity of about 10.9 minutes and in the vicinity of from 8.0 to 10.0 were confirmed. Furthermore, a small amount of the reaction solution as taken out was added dropwise to a mixed solvent of methanol and benzene (mixing mass ratio: 1/1) to cause reprecipitation, and the thus purified solid was taken out and subjected to FT-IR measurement. As a result, a peak caused due to an iminocarbonate group in the vicinity of 1,700 cm⁻¹ and strong peaks caused due to a triazine ring in the vicinity of 1,560 cm⁻¹ and in the vicinity of 1,380 cm⁻¹ could be confirmed, and thus, it was confirmed that the thermosetting resin (A2-3) was produced.

### Comparative Production Example 4: Production of thermosetting resin (A2-4)

In a reaction vessel having a capacity of 3 liters, which was capable of being heated and cooled and which was equipped with a thermometer, an agitator, and a reflux condenser, 500 g of a bisphenol A type cyanate resin (a trade name: Arocy B-10, manufactured by Lonza Japan Ltd.), 500 g of a siloxane resin represented by the foregoing formula (V) (a trade name: X-22-1821, manufactured by Shin-Etsu Chemical Co., Ltd., hydroxyl equivalent: 1,600 g/eq.), and 1,000 g toluene were blended, and the temperature was increased while agitating. After reaching 120°C, 0.01 g of an 8 % by mass mineral spirit solution of zinc naphthenate was added, and the contents were subjected to a reflux reaction at about 100°C for 2 hours. Thereafter, the reaction mixture was cooled to room temperature (25°C), thereby obtaining a solution of a thermosetting resin (A2-4).

In the solution of the thermosetting resin (A2-4), a precipitate was formed due to crystallization.

A small amount of each of the solution having the siloxane resin (a) and the compound (b) blended therein before the reaction and the solution after the reaction was taken out and subjected to GPC measurement (as reduced into polystyrene, eluant: tetrahydrofuran). A peak area of the bisphenol A type cyanate resin appearing in the vicinity of about 12.4 minutes of a retention time was compared between the solution before the reaction and the solution after the reaction, and a rate of disappearance of the peak area of the solution after the reaction relative to the peak area of the solution before the reaction was calculated. As a result, the rate of disappearance of the peak area in the solution after the reaction was 35 %. Accordingly, a rate of reaction of the compound (b) in the thermosetting resin (A2-4) was 35 % by mole.

### Comparative Production Example 5: Production of thermosetting resin (A2-5)

In a reaction vessel having a capacity of 3 liters, which was capable of being heated and cooled and which was equipped with a thermometer, an agitator, and a reflux condenser, 500 g of a bisphenol A type cyanate resin (a trade name: Arocy B-10, manufactured by Lonza Japan Ltd.), 500 g of a siloxane resin represented by the foregoing formula (V) (a trade name: X-22-1821, manufactured by Shin-Etsu Chemical Co., Ltd., hydroxyl equivalent: 1,600 g/eq.), and 1,000 g toluene were blended, and the temperature was increased while agitating. After reaching 120°C, 0.05 g of an 8 % by mass mineral spirit solution of zinc naphthenate was added, and the contents were subjected to a reflux reaction at about 120°C for 8 hours. Thereafter, the reaction mixture was cooled to room temperature (25°C), thereby obtaining a solution of a thermosetting resin (A2-5).

In the solution of the thermosetting resin (A2-5), turbidity was generated due to an insoluble component.

A small amount of each of the solution having the siloxane resin (a) and the compound (b) blended therein before the reaction and the solution after the reaction was taken out and subjected to GPC measurement (as reduced into polystyrene, eluant: tetrahydrofuran) . A peak area of the bisphenol A type cyanate resin appearing in the vicinity of about 12.4 minutes of a retention time was compared between the solution before the reaction and the solution after the reaction, and a rate of disappearance of the peak area of the solution after the reaction relative to the peak area of the solution before the reaction was calculated. As a result, the rate of disappearance of the peak area in the solution after the reaction was 79 %. Accordingly, a rate of reaction of the compound (b) in the thermosetting resin (A2-5) was 79 % by mole.

### Comparative Production Example 6: Production of thermosetting resin (A2-6)

In a reaction vessel having a capacity of 3 liters, which was capable of being heated and cooled and which was equipped with a thermometer, an agitator, and a reflux condenser, 200 g of a bisphenol A type cyanate resin (a trade name: Arocy B-10, manufactured by Lonza Japan Ltd.), 800 g of a siloxane resin represented by the foregoing formula (V) (a trade name: X-22-1821, manufactured by Shin-Etsu Chemical Co., Ltd., hydroxyl equivalent: 1,600 g/eq.), and 1,000 g toluene were blended, and the temperature was increased while agitating. After reaching 120°C, 0.05 g of an 8 % by mass mineral spirit solution of zinc naphthenate was added, and the contents were subjected to a reflux reaction at about 120°C for 8 hours. Thereafter, the reaction mixture was cooled to room temperature (25°C), thereby obtaining a solution of a thermosetting resin (A2-6).

A small amount of each of the solution having the siloxane resin (a) and the compound (b) blended therein before the reaction and the solution after the reaction was taken out and subjected to GPC measurement (as reduced into polystyrene, eluant: tetrahydrofuran). A peak area of the bisphenol A type cyanate resin appearing in the vicinity of about 12.4 minutes of a retention time was compared between the solution before the reaction and the solution after the reaction, and a rate of disappearance of the peak area of the solution after the reaction relative to the peak area of the solution before the reaction was calculated. As a result, the rate of disappearance of the peak area in the solution after the reaction was 65 %. Accordingly, a rate of reaction of the compound (b) in the thermosetting resin (A2-6) was 65 % by mole.

In addition, peaks of a product of the thermosetting resin appearing in the vicinity of about 10.9 minutes and in the vicinity of from 8.0 to 10.0 were confirmed. Furthermore, a small amount of the reaction solution as taken out was added dropwise to a mixed solvent of methanol and benzene (mixing mass ratio: 1/1) to cause reprecipitation, and the thus purified solid was taken out and subj ected to FT-IR measurement. As a result, a peak caused due to an iminocarbonate group in the vicinity of 1,700 cm⁻¹ and strong peaks caused due to a triazine ring in the vicinity of 1, 560 cm⁻¹ and in the vicinity of 1,380 cm⁻¹ were confirmed.

### Comparative Production Example 7: Production of thermosetting resin (A2-7)

In a reaction vessel having a capacity of 3 liters, which was capable of being heated and cooled and which was equipped with a thermometer, an agitator, and a reflux condenser, 1,000 g of a bisphenol A type cyanate resin (a trade name: Arocy B-10, manufactured by Lonza Japan Ltd.) and 1,000 g toluene were blended, and the temperature was increased while agitating. After reaching 120°C, 0.01 g of an 8 % by mass mineral spirit solution of zinc naphthenate was added, and the contents were subjected to a reflux reaction at from about 120°C for 4 hours. Thereafter, the reaction mixture was cooled to room temperature (25°C), thereby obtaining a solution of a thermosetting resin (A2-7).

A small amount of each of the solution having the siloxane resin (a) and the compound (b) blended therein before the reaction and the solution after the reaction was taken out and subjected to GPC measurement (as reduced into polystyrene, eluant: tetrahydrofuran). A peak area of the bisphenol A type cyanate resin appearing in the vicinity of about 12.4 minutes of a retention time was compared between the solution before the reaction and the solution after the reaction, and a rate of disappearance of the peak area of the solution after the reaction relative to the peak area of the solution before the reaction was calculated. As a result, the rate of disappearance of the peak area in the solution after the reaction was 45 %. Accordingly, a rate of reaction of the compound (b) in the thermosetting resin (A2-7) was 45 % by mole.

Furthermore, a small amount of the reaction solution as taken out was added dropwise to a mixed solvent of methanol and benzene (mixing mass ratio: 1/1) to cause reprecipitation, and the thus purified solid was taken out and subjected to FT-IR measurement. As a result, strong peaks caused due to a triazine ring in the vicinity of 1,560 cm⁻¹ and in the vicinity of 1,380 cm⁻¹ were confirmed.

### Examples 1 to 10 and Comparative Examples 1 to 9

The compatibilized resin obtained in each of Production Examples 1 to 4, the resin obtained in each of Comparative Production Examples 1 to 3, or the thermosetting resin obtained in each of Production Examples 6 to 8 and Comparative Production Examples 4 to 7 as the component (A) ; the component (B) obtained in Production Example 5 or commercially obtained; and optionally, the component (C), the component (D), and a curing accelerator were mixed in a blending proportion (parts by mass) shown in each of Tables 1 and 2 by using methyl ethyl ketone as a diluent solvent, thereby obtaining a uniform varnish having a resin content of 60 % by mass.

Subsequently, an S-glass cloth having a thickness of 0.2 mm was impregnated in and coated with the obtained varnish and dried upon heating at 160°C for 10 minutes, thereby obtaining a prepreg having a resin content of 55 % by mass.

Four sheets of this prepreg were superimposed, 18 µm-thick electrolytic copper foils were disposed on the upper and lower surfaces thereof, and the resultant was pressed under a pressure of 25 kg/cm² (2.45 MPa) at a temperature of 185°C for 90 minutes, thereby obtaining a copper clad laminate.

The thus obtained copper clad laminate was used, and its adhesiveness to copper foil (copper foil peel strength), glass transition temperature, solder heat resistance, a coefficient of linear thermal expansion, flame retardancy, copper-clad heat resistance (T-300), relative dielectric constant (1 GHz), dielectric tangent (1 GHz), and drillability were measured and evaluated by the foregoing methods. The evaluation results are shown in Tables 1 to 4.

[Table 1]

**Table 1**

| | Example 1 | Example 2 | Example 3 | Example 4 | Example 5 | Example 6 |
|---|---|---|---|---|---|---|
| Thermosetting resin composition (parts by mass) | | | | | | |
| (A) Compatibilized resin (rate of reaction of component (b)) | | | | | | |
| A1-1 (68 %) | 100 | | | | 100 | 100 |
| A1-2 (43 %) | | 100 | | | | |
| A1-3 (43 %) | | | 100 | | | |
| A1-4 (55 %) | | | | 100 | | |
| (B) Fused silica | | | | | | |
| B-1 (Production Example 5) | 150 | | | | | |
| B-2 (SC-2050KNK) | | 100 | | 170 | | |
| B-3 (SC-2050HNK) | | | 200 | | 100 | 100 |
| (C) Inorganic filler | | | | | | |
| AIOOH | | | | | 50 | 50 |
| (D) Inorganic flame retardant assistant | | | | | | |
| KG-1100 | | | | | | 10 |
| Curing accelerator | 0.01 | 0.01 | 0.01 | 0.01 | 0.01 | |
| Performances of laminate | | | | | | |
| (1) Copper foil peel strength (kN/m) | 1.5 | 1.6 | 1.6 | 1.6 | 1.5 | 1.5 |
| (2) Glass transition temperature (°C) | 282 | 265 | 253 | 308 | 281 | 282 |
| (3) Solder heat resistance | Good | Good | Good | Good | Good | Good |
| (4) Coefficient of linear thermal expansion (ppm/°C) | 3.3 | 4.0 | 3.1 | 2.8 | 3.3 | 3.3 |
| (5) Flame retardancy | V-0 | V-0 | V-0 | V-0 | V-0 | V-0 |
| (6) Copper-clad heat resistance (T-300: min) | >60 | >60 | >60 | >60 | >60 | >60 |
| (7) Dielectric characteristics | | | | | | |
| Relative dielectric constant (-) | 4.7 | 4.6 | 4.5 | 4.5 | 4.7 | 4.7 |
| Dielectric tangent (-) | 0.008 | 0.009 | 0.010 | 0.010 | 0.008 | 0.008 |
| (8) Drillability (plating permeation depth) (µm) | 14 | 15 | 13 | 12 | 14 | 3 |

[Table 2]

**Table 2**

| | Comparative Example 1 | Comparative Example 2 | Comparative Example 3 | Comparative Example 4 | Comparative Example 5 |
|---|---|---|---|---|---|
| Thermosetting resin composition (parts by mass) | | | | | |
| (A) Compatibilized resin (rate of reaction of component (b)) | | | | | |
| A1-5 (18 %) | 100 | | | 100 | 100 |
| A1-6 (76 %) | | 100 | | | |
| A1-7 (53 %) | | | 80 | | |
| Epoxy resin (YX-4000) | | | 20 | | |
| (B) Fused silica | | | | | |
| B-1 (Production Example 5) | 150 | 150 | 150 | | |
| B-4 (SO-25R) | | | | 150 | |
| B-5 (SC-1030-MJA) | | | | | 150 |
| Curing accelerator | 0.01 | 0.01 | 0.01 | 0.01 | 0.01 |
| Performances of laminate | | | | | |
| (1) Copper foil peel strength (kN/m) | - | - | - | 0.1 | 0.1 |
| (2) Glass transition temperature (°C) | - | - | - | 130 | 133 |
| (3) Solder heat resistance | - | - | - | Expanded | Expanded |
| (4) Coefficient of linear thermal expansion (ppm/°C) | - | - | - | 14.1 | 16.1 |
| (5) Flame retardancy | - | - | - | Burnt | Burnt |
| (6) Copper-clad heat resistance (T-300: min) | - | - | - | Expanded at the time of temperature increase | Expanded at the time of temperature increase |
| (7) Dielectric characteristics | | | | | |
| Relative dielectric constant (-) | - | - | - | 5.1 | 5.0 |
| Dielectric tangent (-) | - | - | - | 0.017 | 0.019 |
| (8) Drillability (plating permeation depth) (µm) | - | - | - | 33 | 34 |

[Table 3]

**Table 3**

| | Example 7 | Example 8 | Example 9 | Example 10 |
|---|---|---|---|---|
| Thermosetting resin composition (parts by mass) | | | | |
| (A) Compatibilized resin (rate of reaction of component (b)) | | | | |
| A2-1(65%) | 100 | | | 100 |
| A2-2 (43%) | | 100 | | |
| A2-3 (43%) | | | 100 | |
| (B) Fused silica | | | | |
| B-1 (Production Example 5) | 150 | | | |
| B-2 (SC-2050KNK) | | 100 | | |
| B-3 (SC-2050HNK) | | | 200 | 100 |
| (C) Inorganic filler | | | | |
| AIOOH | | | | 50 |
| Curing accelerator | 0.01 | 0.01 | 0.01 | 0.01 |
| Performances of laminate | | | | |
| (1) Copper foil peel strength (kN/m) ., | 1.5 | 1.6 | 1.6 | 1.6 |
| (2) Glass transition temperature (°C) | 282 | 265 | 255 | 300 |
| (3) Solder heat resistance | Good | Good | Good | Good |
| (4) Coefficient of linear thermal expansion (ppm/°C) | 3.3 | 4.0 | 3.1 | 2.8 |
| (5) Flame retardancy | V-0 | V-0 | V-0 | V-0 |
| (6) Copper-clad heat resistance (T-300: min) | >60 | >60 | >60 | >60 |
| (7) Dielectric characteristics | | | | |
| Relative dielectric constant (-) | 4.7 | 4.6 | 4.5 | 4.5 |
| Dielectric tangent (-) | 0.008 | 0.009 | 0.010 | 0.010 |
| (8) Drillability (plating permeation depth) (µm) | 14 | 15 | 13 | 12 |

[Table 4]

**Table 4**

| | Comparative Example 6 | Comparative Example 7 | Comparative Example 8 | Comparative Example 9 |
|---|---|---|---|---|
| Thermosetting resin composition (parts by mass) | | | | |
| (A) Compatibilized resin (rate of reaction of component (b)) | | | | |
| A2-4 (35 %) | 100 | | | |
| A2-5 (79 %) | | 100 | | |
| A2-6 (65 %) | | | 100 | |
| A2-7 (45 %) | | | | 100 |
| (B) Fused silica | | | | |
| B-4 (SO-25R) | | | 100 | |
| Curing accelerator | 0.01 | 0.01 | 0.01 | 0.01 |
| Performances of laminate | | | | |
| (1) Copper foil peel strength (kN/m) | - | - | 0.7 | 0.45 |
| (2) Glass transition temperature (°C) | - | - | 130 | 120 |
| (3) Solder heat resistance | - | - | Expanded | Expanded |
| (4) Coefficient of linear thermal expansion (ppm/°C) | - | - | 14.1 | 16.5 |
| (5) Flame retardancy | - | - | Burnt | V-1 |
| (6) Copper-clad heat resistance (T-300: min) | - | - | Expanded at the time of temperature increase | Expanded at the time of temperature increase |
| (7) Dielectric characteristics | | | | |
| Relative dielectric constant (-) | - | - | 5.1 | 5.1 |
| Dielectric tangent (-) | - | - | 0.017 | 0.023 |
| (8) Drillability (plating permeation depth) (µm) | - | - | 33 | 24 |

In Tables 1 to 4, the commercially obtained component (B), the optionally used component (C), component (D) and curing accelerator, and the epoxy resin and the fused silica used in the Comparative Examples are as follows.

### Component (B)

Fused silica (B-2) : Fused silica obtained by subjecting fused silica to a surface treatment with 1.0 % by mass of N-phenyl-3-aminopropyltrimethoxysilane (a trade name: SC-2050KNK, manufactured by Admatechs Company Limited, diluent solvent: methyl isobutyl ketone)

Fused silica (B-3) : Fused silica obtained by subjecting fused silica to a surface treatment with 1.0 % by mass of N-phenyl-3-aminopropyltrimethoxysilane (a trade name: SC-2050HNK, manufactured by Admatechs Company Limited, diluent solvent: cyclohexanone)

Fused silica (B-4) : Fused silica (a trade name: SO-25R, manufactured by Admatechs Company Limited)

Fused silica (B-5) : Fused silica obtained by subjecting fused silica to a surface treatment with 1.0 % by mass of γ-glycidoxypropyltrimethoxysilane represented by the following formula (VIII) (a trade name: SC1030-MJA, manufactured by Admatechs Company Limited, diluent solvent: methyl ethyl ketone) 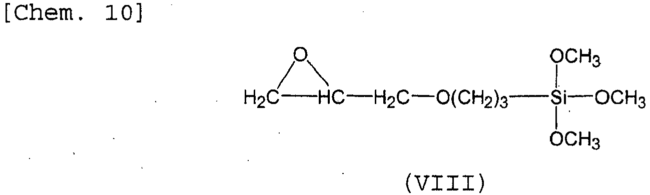
(C) Inorganic filler (AlCOOH): Boehmite type aluminum hydroxide (a trade name: BMT-3L, manufactured by Kawai Lime Industry Co., Ltd., thermal decomposition temperature: 400°C)
(D) Inorganic flame retardant assistant (KG-1100): Inorganic flame retardant assistant having zinc molybdate carried on talc (a trade name: Kemgard 1100, manufactured by Sherwin-Williams Co.)

Curing accelerator: 8 % by mass of mineral spirit solution of zinc naphthalate

Epoxy resin (YX-4000) used in Comparative Example 3: Biphenyl type epoxy resin (a trade name: YX-4000, manufactured by Japan Epoxy Resin Co., Ltd., epoxy equivalent: 186)

In Table 2, in Comparative Examples 1 to 3, the performances of the laminates could not be evaluated for the following reasons.

### Comparative Example 1:

The thermosetting resin was deposited, so that a varnish could not be produced.

### Comparative Example 2:

The moldability was poor, so that a laminate could not be fabricated.

### Comparative Example 3:

The resin was separated, so that a prepreg and a laminate could not be fabricated.

In addition, in Table 4, as for each of Comparative Examples 6 to 7, in the thermosetting resin composition, the thermosetting resin (A) was deposited, so that a varnish could not be produced, and hence, the evaluation could not be achieved.

As is clear from Table 1, Examples 1 to 6 according to the present invention are excellent in terms of all of copper foil peel strength, glass transition temperature (Tg), solder heat resistance, low thermal expansion, flame retardancy, copper-clad heat resistance (T-300), low dielectric characteristics, dielectric tangent, and drillability and satisfy the standard values mentioned in the Background Art.

On the other hand, as is clear from Table 2, none of Comparative Examples 1 to 5 satisfies all of copper foil peel strength, glass transition temperature (Tg), solder heat resistance, low thermal expansion, flame retardancy, copper-clad heat resistance (T-300), low dielectric characteristics, dielectric tangent, and drillability, and they are inferior in terms of any one of the characteristics.

In addition, as is clear from Tables 3 and 4, it is noted that Examples 7 to 10 according to the present invention are excellent in terms of all of copper foil peel strength, glass transition temperature (Tg), solder heat resistance, low thermal expansion, flame retardancy, copper-clad heat resistance (T-300), low dielectric characteristics, dielectric tangent, and drillability and satisfy the foregoing standard values. Comparative Examples 8 to 9 are lower than the standard values in terms of all of copper foil peel strength, glass transition temperature (Tg), solder heat resistance, low thermal expansion, flame retardancy, copper-clad heat resistance (T-300), low dielectric characteristics, dielectric tangent, and drillability.

### [Industrial Applicability]

According to the foregoing Examples, not only the thermosetting resin composition according to the present invention is excellent in terms of solder heat resistance and flame retardancy, but it reaches the levels required in high density and high reliability in recent years in terms of all of the characteristics mentioned in the Background Art, inclusive of adhesiveness to copper foil (copper foil peel strength), copper-clad heat resistance (T-300), drillability, relative dielectric constant, and dielectric tangent.

In consequence, by using the thermosetting resin composition according to the present invention, the high density and high reliability of wiring boards required at present are achieved, and the thermosetting resin composition according to the present invention can be widely used for production of electronic appliances and the like.

## Claims

1. A process for producing a compatibilized resin having an iminocarbonate structure and a triazine structure, comprising reacting (a) a siloxane resin having a hydroxyl group at an end thereof, which is represented by the following general formula (I), (b) a compound having at least two cyanate groups in one molecule thereof, and (c) a compound having at least two epoxy groups in one molecule thereof, with proportions of the component (a), the component (b), and the component (c) being from 10 to 50 parts by mass, from 40 to 80 parts by mass, and from 10 to 50 parts by mass, respectively based on 100 parts by mass of a total amount of the components (a) to (c), in the presence of (d) an organic metal salt in a solvent selected among toluene, xylene, and mesitylene at from 80 to 120°C at a rate of reaction of the component (b) of from 30 to 70 % by mole: 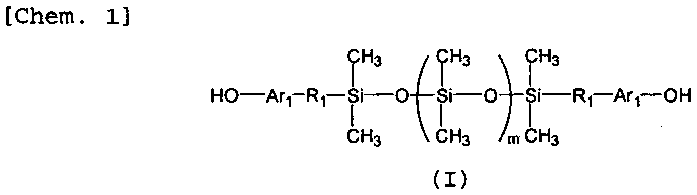 wherein each R₁ independently represents an alkylene group or an alkylene oxy group each having a carbon number of from 1 to 5; each Ar₁ independently represents a single bond, an arylene group, or an alkylene group having a carbon number of from 1 to 5; and m represents an integer of from 5 to 100.

2. A thermosetting resin composition comprising (A1) a compatibilized resin produced by the process according to claim 1.

3. A thermosetting resin composition comprising (A1) a compatibilized resin produced by the process according to claim 1 and (B) fused silica having been subjected to a surface treatment with a trimethoxysilane compound represented by the following formula (II):

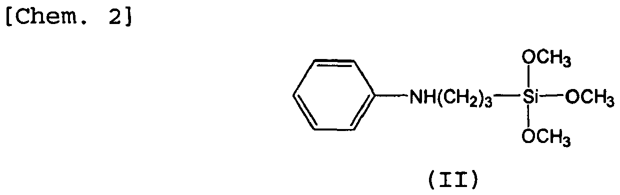

4. A thermosetting resin composition comprising (A2) a thermosetting resin and (B) fused silica having been subjected to a surface treatment with a trimethoxysilane compound represented by the formula (II), wherein
the thermosetting resin (A2) is a resin obtained by reacting (a) a siloxane resin having a hydroxyl group at an end thereof, which is represented by the general formula (I), and (b) a compound having at least two or more cyanate groups in one molecule thereof in an organic solvent,
from 10 to 70 parts by mass of the siloxane resin (a) and from 30 to 90 parts by mass of the compound (b) are contained based on 100 parts by mass of a total sum of the siloxane resin (a) and the compound (b), and
a rate of reaction of the compound (b) is from 40 to 70 % by mole.

5. A prepreg obtained by impregnating or coating a base material with the thermosetting resin composition according to claim 2 or 4 and then bringing it into a B-stage.

6. A laminate formed using the prepreg according to claim 5.

## Patentansprüche

1. Verfahren zur Herstellung eines kompatibilisierten Harzes, das eine Imincarbonatstruktur und eine Triazinstruktur aufweist, umfassend das Umsetzen (a) eines Siloxanharzes, das eine Hydroxylgruppe an einem Ende davon aufweist, dargestellt durch die folgende allgemeine Formel (I), (b) einer Verbindung, die mindestens zwei Cyanatgruppen in ihrem Molekül aufweist und (c) einer Verbindung, die mindestens zwei Epoxygruppen in ihrem Molekül aufweist, wobei die Anteile der Komponente (a), der Komponente (b) und der Komponente (c) von 10 bis 50 Massenteile, von 40 bis 80 Massenteile bzw. von 10 bis 50 Massenteile sind, jeweils auf Basis von 100 Massenteilen der Gesamtmenge der Komponenten (a) bis (c), in Gegenwart (d) eines organischen Metallsalzes, in einem Lösungsmittel ausgewählt aus Toluol, Xylol und Mesitylen bei 80 bis 120°C bei einer Reaktionsrate der Komponente (b) von 30 bis 70 mol%: 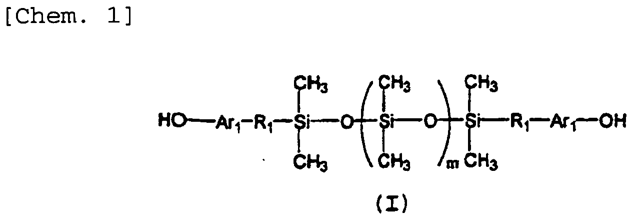 worin jedes R₁ unabhängig eine Alkylengruppe oder eine Alkylenoxygruppe darstellt, die jeweils eine Kohlenstoffanzahl von 1 bis 5 aufweisen; jedes Ar₁ unabhängig eine Einfachbindung, eine Arylengruppe oder eine Alkylengruppe mit einer Kohlenstoffanzahl von 1 bis 5 darstellt; und m eine ganze Zahl von 5 bis 100 darstellt.

2. Wärmehärtende Harzzusammensetzung, umfassend (A1) ein kompatibilisiertes Harz, hergestellt durch das Verfahren gemäß Anspruch 1.

3. Wärmehärtende Harzzusammensetzung, umfassend (A1) ein kompatibilisiertes Harz, hergestellt durch das Verfahren gemäß Anspruch 1 und (B) Siliziumdioxid, das einer Oberflächenbehandlung mit einer Trimethoxysilanverbindung der folgenden Formel (II) unterzogen wurde:

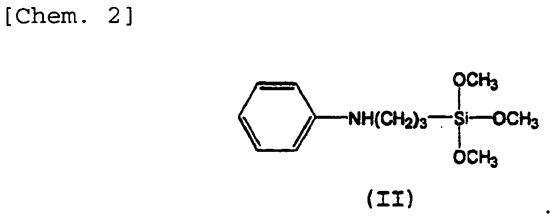

4. Wärmehärtende Harzzusammensetzung, umfassend (A2) ein wärmehärtendes Harz und (B) Siliziumdioxid, das einer Oberflächenbehandlung mit einer Trimethoxysilanverbindung der Formel (II) unterzogen wurde, worin
das wärmehärtende Harz (A2) ein Harz ist, das durch Umsetzen (a) eines Siloxanharzes, das eine Hydroxylgruppe an einem Ende davon aufweist, dargestellt durch die allgemeine Formel (I) und (b) einer Verbindung, die mindestens zwei oder mehr Cyanatgruppen in ihrem Molekül aufweist, in einem organischen Lösungsmittel erhalten wird,
wobei 10 bis 70 Massenteile des Siloxanharzes (a) und 30 bis 90 Massenteile der Verbindung (b) auf Basis von 100 Massenteilen der gesamten Summe des Siloxanharzes (a) und der Verbindung (b) enthalten sind, und
eine Reaktionsrate der Verbindung (b) von 40 bis 70 mol% ist.

5. Prepreg, das durch Imprägnieren oder Beschichten eines Basismaterials mit der wärmehärtenden Harzzusammensetzung gemäß Anspruch 2 oder 4 und dann Überführen in einen B-Zustand erhalten wird.

6. Laminat, das unter Verwendung des Prepreg gemäß Anspruch 5 gebildet ist.

## Revendications

1. Procédé de production d'une résine compatibilisée ayant une structure iminocarbonate et une structure triazine, comprenant la réaction (a) d'une résine siloxane ayant un groupe hydroxyle à une extrémité de celle-ci, qui est représentée par la formule générale (I) suivante, (b) un composé ayant au moins deux groupes cyanate dans une molécule de celui-ci, et (c) un composé ayant au moins deux groupes époxy dans une molécule de celui-ci, avec des proportions du composant (a), du composant (b), et du composant (c) étant de 10 à 50 parties en masse, de 40 à 80 parties en masse, et de 10 à 50 parties en masse, respectivement sur la base de 100 parties en masse d'une quantité totale des composants (a) à (c), en présence de (d) un sel de métal organique dans un solvant choisi parmi le toluène, le xylène, et le mésitylène à de 80 à 120°C à un taux de réaction du composant (b) de 30 à 70% par mole : 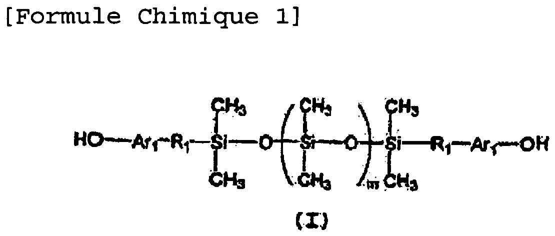 dans laquelle chaque R₁ représente indépendamment un groupe alkylène ou un groupe alkylèneoxy ayant chacun un nombre de carbones de 1 à 5 ; chaque Ar₁ représente indépendamment une liaison simple, un groupe arylène, ou un groupe alkylène ayant un nombre de carbones de 1 à 5 ; et m représente un entier de 5 à 100.

2. Composition de résine thermodurcissable comprenant (A1) une résine compatibilisée produite par le procédé selon la revendication 1.

3. Composition de résine thermodurcissable comprenant (A1) une résine compatibilisée produite par le procédé selon la revendication 1 et (B) une silice fondue ayant été soumise à un traitement de surface avec un composé triméthoxysilane représenté par la formule (II) suivante :

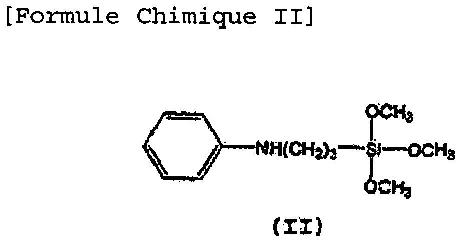

4. Composition de résine thermodurcissable comprenant (A2) une résine thermodurcissable et (B) une silice fondue ayant été soumise à un traitement de surface avec un composé triméthoxysilane représenté par la formule (II), dans laquelle
la résine thermodurcissable (A2) est une résine obtenue en faisant réagir (a) une résine siloxane ayant un groupe hydroxyle à une extrémité de celle-ci, qui est représentée par la formule générale (I), et (b) un composé ayant au moins deux groupes cyanate ou plus dans une molécule de celui-ci dans un solvant organique,
de 10 à 70 parties en masse de la résine siloxane (a) et de 30 à 90 parties en masse du composé (b) sont contenues sur la base de 100 parties en masse d'une somme totale de la résine siloxane (a) et du composé (b), et
un taux de réaction du composé (b) est de 40 à 70% par mole.

5. Préimprégné obtenu en imprégnant ou en revêtant un matériau de base avec la composition de résine thermodurcissable selon la revendication 2 ou 4 et ensuite en l'amenant à un état B.

6. Stratifié formé en utilisant le préimprégné selon la revendication 5.
